# EUROPÄISCHE PATENTSCHRIFT

(11) **EP 1 956 111 B1**
(45) Veröffentlichungstag und Bekanntmachung des Hinweises auf die Patenterteilung: **08.09.2010**
(21) Anmeldenummer: 07002828.7
(22) Anmeldetag: 09.02.2007
(51) Int. Cl.: C23C 14/56

(54) **Anlage mit einer Transportvorrichtung zur Behandlung von Substraten**
Apparatus with a transport device for processing substrates
Installation avec un dispositif de transport destinée au traitement de substrats

(43) Veröffentlichungstag der Anmeldung: 13.08.2008
(73) Patentinhaber: Applied Materials, Inc., Santa Clara, CA 95054 (US)
(72) Erfinder: Fritsche, Wolf-Eckart, 63796 Kahl am Main (DE)
(74) Vertreter: Bockhorni & Kollegen

(56) Entgegenhaltungen:
- WO-A-2004/013375
- DE-A1- 10 205 168
- GB-A- 2 171 119

## Beschreibung

Die Erfindung betrifft eine Anlage, insbesondere Vakuumsbeschichtungsanlage, zur Behandlung von Substraten mit einer Transportvorrichtung mit aneinander gereihten Transportsegmenten zum kontinuierlichen Inline-Transport der Substrate entlang einer Transportlinie durch mehrere Behandlungssektionen, wovon wenigstens eine Behandlungssektion mindestens ein Behandlungswerkzeug aufweist, wobei zur Positionierung jeweils eines Substrates in eine stationäre Position ein Transfermittel vorgesehen ist, welches übereinstimmende, bewegliche Kombi-Segmente aufweist, mittels derer das Substrat positionierbar ist, und die Kombi-Segmente in einer wechselweisen Zuordnung zur Transportlinie ein Transportsegment bilden.

Transportvorrichtungen dieser Art sind in Anlagen zur Substratbehandlung in mehreren nacheinander folgenden Behandlungssektionen, beispielsweise in Vakuum-Beschichtungsanlagen zur Mehrfachbeschichtung von beispielsweise Spezialgläsern, vorzufinden. Dabei werden in einer Inline-Anordnung, d.h. in einer Reihenschaltung, verschiedene Behandlungssektionen, wie Vorbehandlungs-, Nachbehandlungs- und Beschichtungssektionen mit Beschichtungswerkzeugen angeordnet, durch die die Substrate mittels der Transportvorrichtung nacheinander transportiert werden. Entsprechend der konfigurierten Abfolge der Beschichtungsprozesse in den Beschichtungssektionen werden verschiedenste Schichtsysteme aus mehreren Schichten in Variation des Schichtmaterials und der Schichtdicke durch beispielsweise Bedampfen oder Sputtern auf das Substrat aufgetragen. Die Variationen in den Schichtsystemen führen zu unterschiedlichen Verweilzeiten der Substrate in den einzelnen Beschichtungssektionen. Beispielsweise ziehen unterschiedliche Schichtdicken bei gleichbleibender Sputterrate der Beschichtungsprozesse Beschichtungszeiten in einem annähernd proportionalen Verhältnis zur Schichtdicke nach sich. So erfordert eine zweifache Schichtdicke gegenüber den übrigen Schichtdicken des Schichtsystems eine doppelte lange Verweilzeit des Substrates in derjenigen Beschichtungssektion für das Auftragen dieser Schichtdicke. Bei einer Inline- Konfiguration der Anlage mit sequentieller Beschichtung bestimmt jedoch die längste Verweilzeit der Substrate in einer der Prozessstationen die Zykluszeit des kontinuierlichen Substratdurchlaufes durch die Beschichtungsanlage. Ist ein Beschichtungsprozessschritt mit einer außerordentlichen langen Verweilzeit im Vergleich zu den übrigen Prozessschritten der Substratbehandlung erforderlich, führt das im Ergebnis zu einer ungenügenden Auslastung der Beschichtungssektionen mit den kürzeren Verweilzeiten und insgesamt zu einer geringen Produktivität der Beschichtungsanlage.

Zur Lösung dieses Problems der Inline- Anlagenkonfiguration wird im Stand der Technik eine Transportvorrichtung mit einem Transfermittel zur Positionierung jeweils eines Substrates in eine stationäre Position außerhalb der Transportlinie nach der WO 2004/013375 A1 vorgeschlagen. Diese Anlagenkonfiguration umfasst mehrere in Linie aneinander gereihte Module M zur Vakuumbehandlung von Substraten mit einer Transportvorrichtung zum Transport der Substrate zwischen den Modulen M und mit einem Transfermittel zum separaten Positionieren eines Substrates innerhalb des Moduls M, so dass mittels des Transfermittels ein Substrat für eine spezielle Behandlung innerhalb eines Moduls platziert wird, während ein anderes Substrat mittels der Transportvorrichtung zur Behandlung in ein benachbartes Modul M vorbeigeführt werden kann. Die Transportvorrichtung verfügt in jedem Modul über je ein Transportsegment aus paarweise angeordneten, von den Rädern 3, 4 angetriebenen Riemen 1, 2 (Fig. 1 der Druckschrift und zugehörige Beschreibung). Auf diesen Riemen 1, 2 wird ein Substrathalter 9, auf dem das Substrat S gelagert ist, horizontal in der Inline- Transportrichtung auf der unteren Ebene B fortbewegt und von Modul zu Modul übergeben. Zur Übertragung der linearen Fortbewegungskraft sind im Substrathalter Kerben 9a vorgesehen, die in Vorsprünge 8 der Riemen 1, 2 eingreifen (Fig. 3 und 4 der Druckschrift und zugehörige Beschreibung). Das Transfermittel umfasst einen Tragrahmen 11 mit einer Plattform 10, der mittels einer angetriebenen Hebevorrichtung 14, unterstützt von den drehbar gelagerten Hebeln 12 und 13 höhenverstellbar ist ( Fig. 5 und 6 der Druckschrift und zugehörige Beschreibung). Diese Konstruktion des Transfermittels ist zwischen den Riemen 1, 2 und unterhalb der Kraftübertragungsebene der Riemen 1, 2 in das Unterteil des Moduls absenkbar, so dass eine ungehinderte horizontale Transportbewegung der Substrate S mittels der Riemen stattfinden kann (Fig. 3 und 4 der Druckschrift). Hat ein Substrat die entsprechende Position in Ausrichtung zu einer Behandlungskammer C gegenüber der Öffnung 16b erreicht, wird die Hebevorrichtung 14 aktiviert, die eine Vertikalbewegung der Plattform 10 gemeinsam mit dem Substrathalter 9 und dem Substrat S in Richtung der oberen Ebene A bewirkt, wobei der Substrathalter 9 von den Riemen 1, 2 abgelöst wird ( Fig. 5 und 6 der Druckschrift). Während sich die Plattform 10 mit dem Substrat S in der oberen Position A befindet und eine Substratbehandlung in der Behandlungskammer C ausgeführt wird, kann ein anderes Substrat S1 linear von einem zum nächsten Modul vorbei am Substrat S zu einer Behandlung in einer nachfolgenden Behandlungskammer C transportiert werden. (Fig. 1 der Druckschrift). Damit können besonders zeitaufwändige Behandlungsschritte an Substraten zeitlich parallel stattfinden, so dass die Zykluszeit einer Inline- Anlage nicht mehr durch diesen Behandlungsprozess bestimmt wird und damit verringert wird. Außerdem können mit Hilfe dieser Bypassfunktion verschiedene Schichtsysteme seriell in einer Anlage hergestellt werden.

Nachteilig an der Lösung nach dem Stand der Technik ist jedoch, dass zur Umlenkung von der horizontal gerichteten Inline-Bewegung in die vertikale Bewegung zur Positionierung in die Behandlungsposition das Substrat von der Transportvorrichtung an das spezielle Transfermittel übergeben werden muss. Mit der Übergabe des Substrates (inklusive des Substrathalters) an das Transfermittel wird der formschlüssige Eingriff zur Kraftübertragung der horizontalen Linearbewegung gelöst und umgekehrt ist dieser Eingriff mit der Übergabe des Substrates bzw. des Substrathalters an die Transportvorrichtung exakt wieder herzustellen. Diese Übergabe des Substrates von einem unabhängigen Transportsystem in ein anderes unabhängiges Transportsystem ist regelmäßig mit Abweichungen der Positioniergenauigkeit verbunden, gleich ob es sich um ein Riementransport-, ein Schienentransport- oder ein anderes Transportsystem handelt, und bildet daher eine permanente Stör- und Fehlerquelle im Prozessablauf. Außerdem verlangt die Konstruktion des Transfermittels, die für eine ungehinderte horizontale Linearbewegung des Substrates als eine Umbauung der Transportvorrichtung gestaltet sein muss, einen erheblichen Platzbedarf innerhalb der Vakuum-Behandlungsmodule.

Eine weitere Transportvorrichtung mit einem Transfermittel ist aus der GB 2 171 119 A bekannt, welche in einer Vakuumprozessanlage mit mehreren verschiedenen, aneinander gereihten Vakuumkammern Verwendung findet, Die Anlage umfasst z.B. eine Schleusenkammer 18, eine Zwischenkammer 16, eine Eintrittspufferkammer 12, eine Prozesskammer 10 und eine Endpufferkammer 14. In der Prozesskammer 10 findet beispielsweise eine Beschichtung der Werkstücke mittels der Beschichtungswerkzeuge (Sputterquellen) 11 statt. Für den Transport der Werkstücke entlang der Transportlinie 48 ist in jeder der separaten Vakuumkammern ein Fördermittel vorgesehen, welches Rollen 42 aufweist, die an einem Rahmen 44 befestigt sind und von einem umschaltbaren Motor 46 angetrieben werden. Die Fördermittel aller Kammern sind zueinander ausgerichtet, so dass die Werkstücke entlang der Transportlinie 48 in und aus der Anlage geführt werden können. Dabei durchlaufen die Werkstücke die Vakuumkammern nach Bedarf vor- und rückwärts und verweilen in den einzelnen Vakuumkammern entsprechend der Dauer der individuellen Behandlungsmaßnahmen. In der Zwischenkammer 16 ist eine Mehr-Ebenen-Transporteinrichtung 50 als Transfermittel zum separaten Positionieren eines Substrates außerhalb der Transportlinie 48 vorgesehen. Die Transporteinrichtung 50 ist vertikal beweglich weist zwei horizontal ausgerichtete Fördermittel 52, 54 auf, die an einem gemeinsamen Rahmen 60 übereinander befestigt sind (Fig. 1 der Druckschrift und zugehörige Beschreibung) Fig. 4 der Druckschrift zeigt die verschiedenen Stellungen der Transporteinrichtung 50 bei wechselweiser Zuordnung der kombinierbaren Fördermittel 52, 54 zu den aneinander gereihten Fördermitteln entlang der Transportlinie 48. Die Transporteinrichtung 50 positioniert jeweils ein Werkstückes parallel oberhalb oder unterhalb der Transportlinie und dient damit zum parallelen Zwischenparken zweier Werkstücke in der Zwischenkammer, welche dort auf einem definierten Vakuumdruckniveau vorgehalten werden. Damit wird zwar der Werkstück- Wechselvorgang in und aus der benachbarten Prozesskammer 10 beschleunigt, jedoch werden hierdurch die besonders zeitaufwändigen Behandlungsschritte, nämlich die Beschichtung der Werkstücke mit den Beschichtungswerkzeugen der Prozesskammer, welche die Zykluszeit der Inline- Anlage maßgeblich bestimmen, nicht zeitsparend beeinflusst.

Ausgehend davon ist es die Aufgabe der vorliegenden Erfindung, eine Anlage der gattungsgemäßen Art dahingehend weiterzuentwickeln, dass deren Funktionalität zur Gewährleistung reduzierter Zykluszeiten mit einfachen Mitteln verbessert und so eine Erhöhung des Durchsatzes an Substraten erzielt wird.

Diese Aufgabe wird erfindungsgemäß durch eine Anlage gemäß Anspruch 1 gelöst.

Bei der erfindungsgemäßen Anlage ist mittels des Kombi-Segmentes des Transfermittels das Substrat in eine stationäre Behandlungsposition positionierbar, bei der das Substrat dem Behandlungswerkzeug gegenüberliegend zugeordnet ist. Jeweils eines der Kombi-Segmente ist in die Aneinanderreihung der Transportsegmente entlang der Transportlinie als ein Transportsegment eingeordnet, während mindestens ein weiteres Kombi-Segment außerhalb der Transportlinie so angeordnet ist, dass das darauf befindliche Substrat in eine stationäre Behandlungsposition positioniert ist, bei der das Substrat dem Behandlungswerkzeug gegenüberliegend zugeordnet ist.

Das den Transportsegmenten zugeordnete Kombi-Segment bewirkt in der Art eines Kettengliedes einen Verbund mit den benachbarten Transportsegmenten der Transportvorrichtung, ebenso wie der Verbund der übrigen Transportsegmente untereinander. Sofern sich ein Substrat bzw. ein Substrathalter entlang der Transportlinie in Eingriff mit diesem Kombi-Segment befindet, bewirkt das Transfermittel einen Versatz dieses Kombi-Segmentes aus der Transportlinie heraus, zur gezielten Positionierung des Substrates in eine stationäre Behandlungsposition, bei der das Substrat einem Behandlungswerkzeug, wie zum Beispiel einer Sputterbeschichtungsquelle, gegenüber liegt und von diesem bearbeitet wird. Gleichzeitig wird wechselseitig die entstehende "Lücke" in der Transportlinie durch ein weiteres, identisches Kombi-Segment des Transfermittels egalisiert. Dieses Kombi-Segment reiht sich anstelle des versetzen Kombi-Segmentes in die Transportsegmente ein und bewirkt wiederum den vorbeschriebenen Verbund mit den benachbarten Transportsegmenten der Transportvorrichtung. Die Transportvorrichtung ist damit ohne Einschränkung und Störeinflüsse auf einfache Weise ununterbrochen für den kontinuierlichen Inline- Transport der Substrate nutzbar, so dass ein weiteres Substrat an dem vorangegangenen und versetzt positionierten Substrat vorbei, zu einer folgenden Behandlungssektion befördert werden kann, um dort parallel bearbeitet zu werden. Im umgekehrten Vorgang wechselt mit Herausführung des eingereihten Kombi-Segmentes aus der Transportlinie gleichzeitig das versetzte Kombi-Transportelement wieder in die bereitgestellte Lücke der Transportsegmente ein, so dass auch ein außerhalb der Transportlinie positioniertes und bearbeitetes Substrat ohne beeinträchtigende Übergänge und Störeinflüsse von der Transportvorrichtung weiter gefördert werden kann. Die erfindungsgemäße Transportvorrichtung ermöglicht damit einen kontinuierlichen Inline-Transport der Substrate durch die Anlage, unter Wahrung einer hohen Transportgenauigkeit, wobei der Inline-Transport von der erheblichen Verweildauer der in einer Behandlungssektion mit Behandlungswerkzeug zu bearbeitenden Substrate unbeeinflusst ist. Folglich reduziert sich die Zykluszeit der Anlage, die sich nunmehr unabhängig von der längsten Verweildauer eines Substrates an einem Behandlungswerkzeug bestimmt.

Mit den in den Unteransprüchen 2 bis 13 aufgeführten Maßnahmen sind vorteilhafte Weiterbildungen der im Anspruch 1 angegebenen erfindungsgemäßen Anlage verbunden.

In einer bevorzugten Ausführungsform sind die Kombi-Segmente zueinander parallel beabstandet angeordnet. Damit können die Kombi-Segmente gleichzeitig mit nur einem Stellantrieb in ihrer Lage verstellt oder verschoben werden.

Sind die Kombi-Segmente insbesondere senkrecht zur Transportlinie verfahrbar, minimiert sich der Positionierungsaufwand zur wechselweisen Zuordnung der Kombi-Segmente weiter, wobei sich je nach der Ausführung der Transportvorrichtung und der Orientierung der Transportlinie vorzugsweise ein Horizontal- oder ein Vertikal- Versatz der Kombi-Segmente zur Transportlinie anbietet. Das horizontale Verschieben oder das vertikale Heben und Senken der Kombi-Segmente wird mittels eines entsprechend geeigneten und konstruktiv günstigen Rollen- oder Zahnradtriebes oder eines Schub- oder Zugmitteltriebes realisiert, der jeweils elektrisch, pneumatisch oder hydraulisch betreibbar ist.

Bevorzugter Weise ist jeweils ein Transfermittel in mindestens zwei aufeinander folgenden Behandlungssektionen vorgesehen oder mindestens zwei aufeinander folgenden Behandlungswerkzeugen zugeordnet. Damit können länger dauernde Behandlungsprozesse in der Anlage mehrfach konzipiert werden und sowohl eine serielle wie auch parallele Behandlung von Substraten vorgenommen werden. Die Zykluszeit der Inline- Anlage wird nicht mehr durch diesen langen Behandlungsprozess bestimmt und verringert sich damit. So kann das erste Substrat in der ersten Behandlungssektion bzw. durch das erste Behandlungswerkzeug behandelt werden und das in Transportrichtung nachfolgende zweite Substrat an das erste Substrat vorbei zur nächstfolgenden Behandlungssektion bzw. zum nächstfolgenden Behandlungswerkzeug transportiert werden und parallel behandelt werden.

Besonders vorteilhaft ist es, wenn das dem Behandlungswerkzeug zugeordnete Kombi-Segment und/oder ein Substrathalter des Substrates als eine Kammertrennwand ausgebildet ist. Mit Versatz des Kombi-Segmentes incl. der Kammertrennwand in Richtung des Behandlungswerkzeuges ist es möglich, die Behandlungssektion abtrennbar in eine Prozesskammer und eine Transportkammer zu teilen. Vorzugsweise durch Anschluss der ausgebildeten Kammertrennwand an Dichtelemente der Kammerwand wird das zu behandelnde Substrat in der Prozesskammer vakuumdicht eingeschlossen. Das während der stationären Behandlung des Substrates über die Transportvorrichtung durch die Behandlungssektion hindurch beförderte Substrat bleibt von diesem Behandlungsprozess unbeeinflusst. So können in den benachbarten Behandlungssektionen unabhängig voneinander verschiedene Behandlungsprozesse ausgeführt werden.

Technologisch günstig ist es, wenn ein flächiges Substrat mit seiner Behandlungsfläche während der stationären Behandlung in einer Ebene parallel zur Substrattransportebene ausgerichtet bleibt, d.h. ohne Änderung der Ausrichtung lediglich flächenparallel verschoben wird. In Transportvorrichtungen mit erfindungsgemäßem Transfermittel ist die Behandlungsfläche des flächigen Substrates vorzugsweise horizontal oder im Wesentlichen vertikal ausgerichtet.

In einer weiteren zweckmäßigen Ausführungsform weist die Transportvorrichtung ein Drehmodul mit mindestens einem Transportsegment auf, welches den Transportsegmenten zweier Behandlungssektionen zuordenbar ist. Ebenso ist es möglich die Transportsegmente zweier Behandlungssektionen über ein linear orientiertes Transportmodul mit mindestens einem Transportsegment miteinander zu verbinden. Weisen die benachbarten Behandlungssektionen jeweils ein erfindungsgemäßes Transfermittel auf, kann man auf diese Weise eine Behandlungsanlage für statische Behandlungen verwirklichen, die sowohl als Inline-Anlage als auch analog einer Cluster-Anlage mit seriellem oder parallelem Zugriff auf die einzelnen Behandlungssektionen betrieben werden kann. Dieser wahlfreie Zugriff auf die einzelnen Behandlungssektionen ermöglicht, dass in keinem Betriebszustand die Fortbewegung der Substrate entlang der Transportlinie blockiert ist. Jedes Substrat kann jeder Zeit zu einer in Transportrichtung freien Behandlungssektion bewegt werden. Mit der erfindungsgemäßen Transportvorrichtung ist bei bestimmten Behandlungsfolgen ein höherer Durchsatz möglich, als beispielsweise bei den bekannten Clusteranlagen mit zentralem Drehmodul, das eine begrenzte Aufnahmekapazität für Substrate hat und somit bei voller Bestückung der Behandlungssektionen überlastet ist.

Die erfindungsgemäße Anlage wird nachfolgend anhand zweier Ausführungsbeispiele näher erläutert. Die zugehörigen Zeichnungen zeigen in einer schematischen Darstellung in
- Fig. 1: Draufsicht einer vertikalen Inline-Beschichtungsanlage nach einem Ausführungsbeispiel A mit zwei Beschichtungssektionen und einer erfindungsgemäßen Transportvorrichtung für im Wesentlichen ver- tikal ausgerichtete Substrate,
- Fig. 2a: Seitenansicht eines erfindungsgemäßen Transfermittels dieser Transportvorrichtung mit zwei Kombi-Segmenten,
- Fig. 2b: Seitenansicht einer alternativen Ausführungsform des erfindungs- gemäßen Transfermittels,
- Fig. 3: Draufsicht einer erweiterten Inline-Beschichtungsanlage nach dem Ausführungsbeispiel A mit einem zwischen geordneten Drehmodul,
- Fig. 4a: Seitenansicht einer horizontalen Inline-Beschichtungsanlage nach einem Ausführungsbeispiel B mit zwei Beschichtungssektionen und einer erfindungsgemäßen Transportvorrichtung für horizontal aus- gerichtete Substrate,
- Fig. 4b: Querschnittsansicht einer Inline-Beschichtungsanlage nach dem Ausführungsbeispiel B.

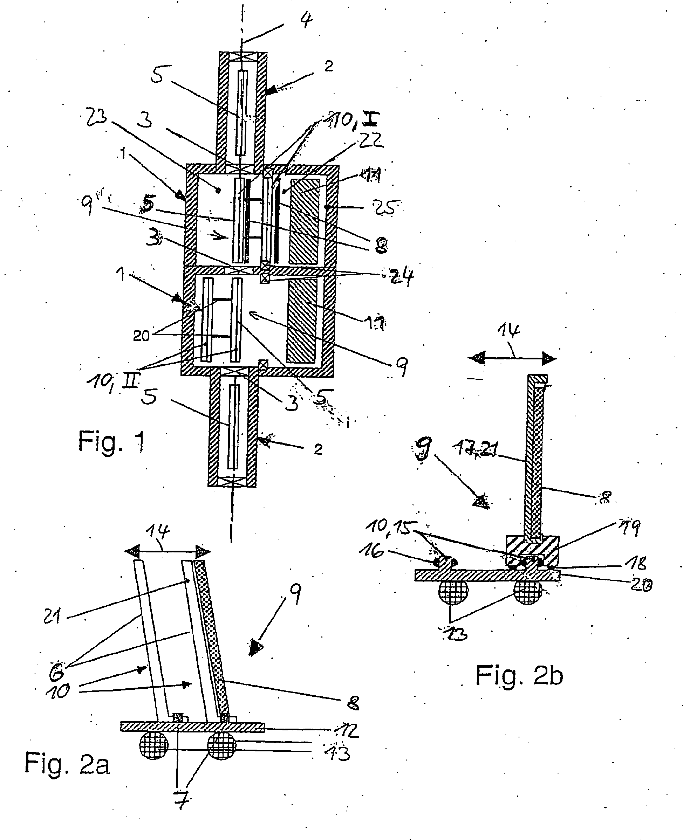

Die vertikale Inline-Beschichtungsanlage nach dem Ausführungsbeispiel A in Fig. 1 besteht aus zwei benachbarten Beschichtungssektionen 1 und zwei angrenzenden Schleusenkammern 2, wobei die Beschichtungssektionen 1 und die Schleusenkammern 2 untereinander durch vakuumdichte Kammerventile 3 trennbar sind. Durch die Schleusenkammern 2 und Beschichtungssektionen 1 verläuft die erfindungsgemäße Transportvorrichtung, die aus mehreren, entlang einer Transportlinie 4 aneinander gereihten Transportsegmenten 5 gebildet ist. Die Transportsegmente 5 nach dem Ausführungsbeispiel A sind für den Transport im Wesentlichen vertikal ausgerichteter flächiger Substrate 8 ausgebildet, wobei speziell die Transportsegmente 5 in Fig. 1 Elemente einer Gaspolster-Transportvorrichtung sind, bei der die Transportsegmente 5 jeweils eine schräg oder im Wesentlichen vertikal orientierte Substratführungsplatte 6 mit am Fuß angeordneten Transportrollen 7 aufweisen (gut ersichtlich aus Fig. 2a), mit deren Hilfe die flächigen Substrate 8 stehend mit leichter Neigung entlang der Transportlinie 4 durch die Inline- Beschichtungsanlage transportiert werden. Dabei schwebt das Substrat 8 auf einem Gaspolster über die Substratführungsplatte 6 des Transportsegmentes 5. In den Beschichtungssektionen 1 ist jeweils ein Transfermittel 9 mit zwei parallel zueinander angeordneten, horizontal verfahrbaren Kombi-Segmenten 10 vorgesehen, die in ihrem Aufbau mit den Transportsegmenten 5 entlang der Transportlinie 4 identisch sind. Fig. 1 zeigt die jeweiligen Transfermittel 9 in den beiden möglichen Stellungen I und II der Kombi-Segmente 10, bei denen jeweils ein Kombi-Segment 10 als ein Transportsegment 5 der Transportlinie 4 zugeordnet ist. In der Stellung I ist das außerhalb der Transportlinie 4 befindliche Kombi-Segment 10 einem Beschichtungswerkzeug 11 zugewandt. In der Stellung II ist das außerhalb der Transportlinie 4 befindliche Kombi-Segment 10 von dem Beschichtungswerkzeug 11 abgewandt.

Fig. 2a zeigt das Transfermittel 9 in einer Seitenansicht, aus der der vorbeschriebene, zu den Transportsegmenten 5 identische Aufbau der Kombi-Segmente 10 und ihre Verfahrweise für den Stellungswechsel ersichtlich ist. Die Kombi-Segmente 10 sind parallel beabstandet mit einer Trägerplatte 12 verbunden, die auf Transferrollen 13 gelagert ist, die beispielsweise durch einen nicht dargestellten Elektromotor oder einen Druckluftzylinder angetrieben sind. Trägerplatte 12 und Transferrollen 13 sind so zu einander ausgerichtet, dass die Kombi-Segmente 10 synchron in einer Transfer-Richtung 14 senkrecht zur Transportlinie 4 horizontal verfahrbar sind und so die Stellungen I und II der Kombi-Segmente 10 verwirklichen. Die Ausrichtung des mit dem Kombi-Segment 10 entlang der Transfer-Richtung 14 beförderten flächigen Substrates 8 bleibt entsprechend der Ausrichtung während des Transportes entlang der Transportlinie 4 erhalten. Trägerplatte 12 und Transferrollen 13 sind unterhalb der Kombi-Segmente 10 angeordnet, so dass sich das jeweils der Transportlinie 4 zugeordnete Kombi-Segment 10 ungehindert als Transportsegment 5 in die übrigen Transportsegmente 5 entlang der Transportlinie 4 einreiht.

Aus Fig. 2b ist eine alternative Ausführungsform des Transfermittels 9 ersichtlich, die zugleich eine alternative Ausführungsform der Transportvorrichtung als Schienen-Transportvorrichtung impliziert. Die mit den Transportsegmenten 5 dieser Ausführungsform identischen Kombi-Segmente 10 bestehen jeweils aus einem Schienensegment 15 mit beidseitig angeordneten, angetriebenen Transportrollen 16. Auf einem der Kombi-Segmente 10 befindet sich ein Substrat 8, welches von einem flächigen Carrier 17 (Substrathalter) gehalten wird und mit einer auf Rollen 18 fahrbaren Carriergondel 19 verbunden ist. In der Stellung, in der dieses Kombi-Segment 10 ein Transportsegment 5 bildet, fährt die Carriergondel 19, angetrieben von den Transportrollen 16, mit dem Substrat 8 auf den aneinander gereihten Schienensegmenten 15 entlang der Transportlinie 4. Anstelle der Schienensegmente 15 mit den Transportrollen 16 kann der Substrattransport auch mittels eines nicht dargestellten Schienensystems erfolgen, bei dem die Schienensegmente 15 als Linearmotor ausgebildet ist, auf dessen Magnetfeld die Carriergondel 19 schwebt. Des Weiteren zeigt Fig. 2b anstelle einer Trägerplatte 12 eine der zwei U-Profil-förmigen Trägerschienen 20, in denen die Transferrollen 13 eingreifen, wodurch die Kombi-Segmente 10 in ihrer Bewegung entlang der Transfer- Richtung 14 gut geführt sind.

Das dem Beschichtungswerkzeug 11 zugewandte Kombi-Segment 10 des Transfermittels 9 positioniert das Substrat 8 dem Beschichtungswerkzeug 11 gegenüberliegend in eine Beschichtungsposition, wie aus Stellung I der Kombi-Segmente 10 in Fig. 1 ersichtlich wird. Somit fungieren die Kombi-Segmente 10 kombiniert sowohl als Transportsegmente 5 als auch als "Positionier-Elemente" für die Positionierung des Substrates 8 in der Behandlungsposition.

Die Substratführungsplatte 6 des Kombi-Segmentes 10 nach Fig. 2a oder alternativ der flächige Carrier 17 nach Fig. 2b ist als eine Kammertrennwand 21 ausgebildet, die in der Stellung I der Kombi-Segmente 10 eine Prozesskammer 22 der Beschichtungssektion 1 von einer Transportkammer 23 funktional trennt. Dabei korrespondiert die Kammertrennwand 21 mit Dichtelementen 24 der Kammerwand 25 der Beschichtungssektion 1, so dass die Prozesskammer 22 während der Beschichtung des Substrates 8 gegenüber der Transportkammer 23 vakuumdicht abgetrennt ist.

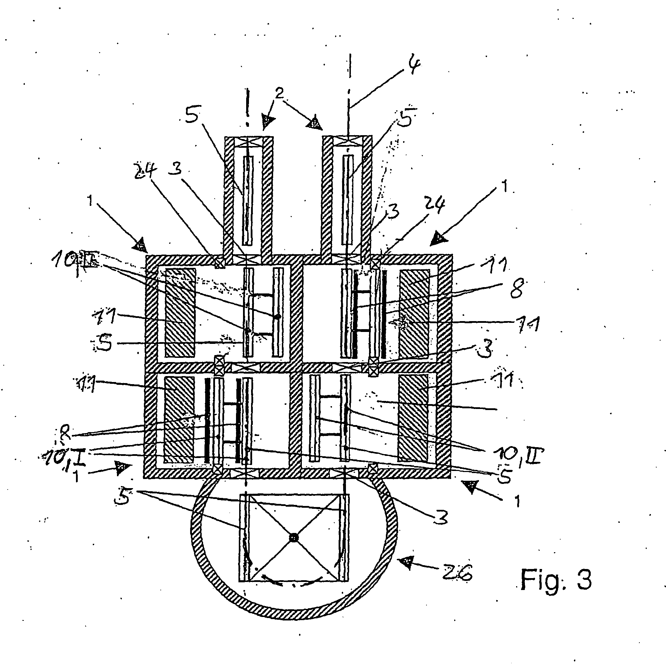

Fig. 3 zeigt eine erweiterte Inline-Beschichtungsanlage nach Fig. 1 mit vier Beschichtungssektionen 1, wobei zwei benachbarte Beschichtungssektionen 1 über ein Drehmodul 26 mit einander verbunden sind. Die Transportsegmente 5 des Drehmoduls 26 schließen wechselseitig an die Transportsegmente 5 der Beschichtungssektionen 1 entlang der Transportlinie 4 an. Dabei führt das Transportsegment 5 des Drehmoduls 26 nicht nur eine Drehbewegung, sondern auch einen Longitudinalbewegung entlang der Transportlinie 4 aus, um dieses Transportsegment 5 mit geringem Abstand an das jeweilige Transportsegment 5 der Beschichtungssektionen 1 anschließen zu können. Auf diese Weise ist die Inline-Beschichtungsanlage analog einer Cluster-Beschichtungsanlage angeordnet, mit wahlfreiem Zugriff auf die dem Drehmodul 26 benachbarten Beschichtungssektionen 1.

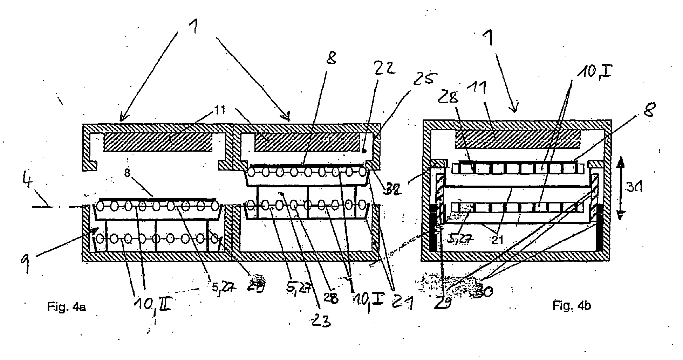

In den Figuren 4a und 4b ist eine horizontale Inline-Beschichtungsanlage nach dem Ausführungsbeispiel B dargestellt. Diese besteht analog zur Inline-Beschichtungsanlage nach dem Ausführungsbeispiel A aus zwei benachbarten Beschichtungssektionen 1, wobei hier die angrenzenden Schleusenkammern 2 und die vakuumdichten Kammerventile 3 zur Vereinfachung der Darstellung entfallen sind. Durch die Beschichtungssektionen 1 und die angrenzenden Schleusenkammern 2 verläuft die erfindungsgemäße Transportvorrichtung, die wiederum aus mehreren, entlang der Transportlinie 4 aneinander gereihten Transportsegmenten 5 besteht. Die Transportsegmente 5 in einer horizontalen Inline-Beschichtungsanlage sind für den Transport horizontal ausgerichteter flächiger Substrate 8 ausgebildet, wobei beispielsweise die Transportsegmente 5 in Fig. 4a und 4b Rollensegmente 27 einer Rollen-Transportvorrichtung sind, bei der die flächigen Substrate 8 liegend über Transportrollen 28 der Rollensegmente 27 geführt und so entlang der Transportlinie 4 durch die Inline- Beschichtungsanlage transportiert werden.

Wie bei der Inline-Beschichtungsanlage nach dem Ausführungsbeispiel A ist auch bei der Inline-Beschichtungsanlage nach dem Ausführungsbeispiel B jeweils ein Transfermittel 9 mit zwei parallel zueinander angeordneten Kombi-Segmenten 10 vorgesehen, die in ihrem Aufbau mit den Transportsegmenten 5, hier speziell mit den Rollensegmenten 27, entlang der Transportlinie 4 identisch sind: Fig. 4a zeigt die jeweiligen Transfermittel 9 in den beiden möglichen Stellungen I und II der Kombi-Segmente 10, bei denen jeweils ein Kombi-Segment 10 als ein Transportsegment 5 der Transportlinie 4 zugeordnet ist. Die Gruppierung der Kombi-Segmente 10 erfolgt analog der Kombi-Segmente 10 der Inline-Beschichtungsanlage nach dem Ausführungsbeispiel A, wobei jedoch die Kombi-Segmente 10 nach dem Ausführungsbeispiel B mittels einer aus Fig. 4b ersichtlichen Hubeinrichtung 30 vertikal verfahrbar sind. Dazu sind die Kombi-Segmente 10, zueinander parallel beabstandet, mit Führungsprofilen 29 verbunden, wobei die Führungsprofile 29 Bestandteil der Hubeinrichtung 30 sind, die über ein nicht näher dargestelltes Getriebe mittels beispielsweise einem Stellmotor oder einem Druckluftzylinder angetrieben ist. Somit sind die Kombi-Segmente 10 synchron in einer vertikalen Transfer-Richtung 31 in die Stellungen I bzw. II verfahrbar, wobei in der Stellung I das auf dem Kombi-Segment 10 angeordnete horizontal ausgerichteten flächigen Substrat 8 dem oberhalb der Transportvorrichtung angeordneten Beschichtungswerkzeug 11 zur Beschichtung zugeführt ist (so auch in Fig. 4b ersichtlich).

Nach dem Ausführungsbeispiel B in Fig. 4a und 4b sind wannenförmige Kammertrennwände 21 vorgesehen, die unterhalb der Transportrollen 28 eines jeden Kombi-Segments 10 angeordnet sind, wobei die jeweils in einer Ebene zwischen den paarweisen Kombi-Segmenten 10 angeordnete Kammertrennwand 21 der funktionalen Trennung der Prozesskammer 22 von der Transportkammer 23 in der Stellung I dient. Dabei korrespondieren die umlaufenden Ränder der wannenförmigen Kammertrennwand 21, die die Transportrollen 28 teilweise umfassen, mit einem dichtenden Auflagerahmen 32 der Kammerwand 25 der Beschichtungssektion 1, so dass auch in dieser Ausführungsform die Prozesskammer 22 während der Beschichtung des Substrates 8 gegenüber der Transportkammer 23 vakuumdicht abgetrennt ist.

Funktionsweise der Inline-Beschichtungsanlage nach den Ausführungsbeispielen A und B:
Die Substrate 8 werden über die Schleusenkammer 2 eingeschleust und mittels der Transportsegmente 5 entlang der Transportlinie 4 transportiert. Hat ein Substrat 8 auf seinem Transportweg die erste Beschichtungssektion 1 erreicht, wird das Substrat 8 von einem der Kombi-Segmente 10 des dortigen Transfermittels 9 aufgenommen, das momentan als Transportsegment 5 dient. Das Transfermittel 9 bewegt mittels der Transferrollen 13 bzw. mittels der Hubeinrichtung 30 beide Kombi-Segmente 10 synchron in horizontaler Transfer-Richtung 14 bzw. in vertikaler Transferrichtung 31 aus der Stellung II auf das Beschichtungswerkzeug 11 zu, bis das Transfermittel 9 das Substrat 8 in die Behandlungsposition gegenüberliegend dem Beschichtungswerkzeug 11 positioniert hat (Stellung I der Kombi-Segmente 10). Die entstandene Lücke in der Aneinanderreihung der Transportsegmente 5 wird gleichzeitig durch das parallele Kombi-Segment 10 geschlossen, das somit wiederum ein Transportsegment 5 entlang der Transportlinie 4 bildet. Das nachfolgende, entlang der Transportlinie 4 transportierte Substrat 8 kann nun die erste Beschichtungssektion 1 ungehindert und störungsfrei passieren, um am vorausgegangenen Substrat 8 vorbei die benachbarte Beschichtungssektion 1 zu erreichen. Dort wird das Substrat 8 von dem Kombi-Segment 10 des dortigen Transfermittels 9 aufgenommen, dass sich in Stellung II der Kombi-Segmente 10 befindet und nachfolgend ebenfalls in die Behandlungsposition positioniert werden kann (Stellung I der Kombi-Segmente 10). Während der Beschichtung des Substrates 8 in der ersten Beschichtungssektion 1 ist mittels der Kammertrennwand 21 die Prozesskammer 22 von der Transportkammer 23 getrennt, so dass das passierende Substrat 8 nicht von dem Beschichtungsprozess in der ersten Beschichtungssektion 1 beeinflusst wird.

Somit ist eine parallele wie auch serielle Beschichtung von Substraten 8 in den benachbarten Beschichtungssektionen 1 möglich. Insbesondere länger dauernde Beschichtungsprozesse an den Substraten 8 können zeitsparend parallel betrieben werden. Dabei wird die Übergabe des Substrates 8 an die entsprechenden Transportsysteme des Inline-Transports und des Transfertransportes zum Zwecke der Substratpositionierung in die stationäre Behandlungsposition und zurück vorteilhaft ohne störbehaftetes Umsetzen des Substrates 8 in die verschiedenen Transportsysteme realisiert.

### Bezugszeichenliste

- 1: Behandlungs-, Beschichtungssektion
- 2: Schleusenkammer
- 3: vakuumdichte Kammerventile
- 4: Transportlinie
- 5: Transportsegment
- 6: Substratführungsplatte
- 7: Transportrolle der Substratführungsplatte
- 8: Substrat
- 9: Transfermittel
- 10: Kombi-Segment
- 11: Behandlungs-, Beschichtungswerkzeug
- 12: Trägerplatte
- 13: Transferrolle
- 14: horizontale Transfer-Richtung
- 15: Schienensegment
- 16: Transportrolle des Schienensegments
- 17: Substrathalter, Carrier
- 18: Rolle der Carriergondel
- 19: Carriergondel
- 20: Trägerschiene
- 21: Kammertrennwand
- 22: Prozesskammer
- 23: Transportkammer
- 24: Dichtelement
- 25: Kammerwand der Beschichtungssektion
- 26: Drehmodul
- 27: Rollensegment
- 28: Transportrolle des Rollensegmentes
- 29: Führungsprofil
- 30: Hubeinrichtung
- 31: vertikale Transfer-Richtung
- 32: dichtender Auflagerahmen

- I: Stellung I der Kombi-Segmente
- II: Stellung II der Kombi-Segmente

## Patentansprüche

1. Anlage, insbesondere Vakuumsbeschichtungsanlage, zur Behandlung von Substraten (8), mit einer Transportvorrichtung, wobei die Transportvorrichtung umfasst:
aneinander gereihte Transportsegmente (5) zum kontinuierlichen Inline-Transport der Substrate (8) entlang einer Transportlinie (4) durch mehrere Behandlungssektionen (1), wovon wenigstens eine Behandlungssektion (1) mindestens ein Behandlungswerkzeug (11) aufweist,
wobei zur Positionierung jeweils eines Substrates (8) in eine stationäre Behandlungsposition ein Transfermittel (9) vorgesehen ist, welches übereinstimmende, bewegliche Kombi-Segmente (10) aufweist, mittels derer das Substrat (8) positionierbar ist,
wobei die Kombi-Segmente (10) in einer wechselweisen Zuordnung zur Transportlinie (4) ein Transportsegment (5) bilden,
wobei mittels der Kombi-Segmente (10) das Substrat (8) in die stationäre Behandlungsposition positionierbar ist, bei der das Substrat (8) dem Behandlungswerkzeug (11) gegenüberliegend zugeordnet ist.

2. Anlage nach Anspruch 1, **dadurch gekennzeichnet, dass** die Kombi-Segmente (10) zueinander parallel beabstandet angeordnet sind.

3. Anlage nach Anspruch 1 oder 2, **dadurch gekennzeichnet, dass** die Kombi-Segmente (10) quer und vorzugsweise senkrecht zur Transportlinie (4) verfahrbar sind.

4. Anlage nach Anspruch 3, **dadurch gekennzeichnet, dass** die Kombi-Segmente (10) horizontal und/oder vertikal verfahrbar sind.

5. Anlage nach Anspruch 3 oder 4, **dadurch gekennzeichnet, dass** das Transfermittel (9) einen Rollen- oder Zahnradtrieb oder einen Schub- oder Zugmitteltrieb aufweist, welcher elektrisch, pneumatisch oder hydraulisch betreibbar ist.

6. Anlage nach einem der vorgenannten Ansprüche, **dadurch gekennzeichnet, dass** jeweils ein Transfermittel (9) in mindestens zwei aufeinander folgenden Behandlungssektionen (1) vorgesehen ist oder mindestens zwei aufeinander folgenden Behandlungswerkzeugen (11) zugeordnet ist.

7. Anlage nach einem der vorgenannten Ansprüche, **dadurch gekennzeichnet, dass** das Transfermittel (9) eine Kammertrennwand (21) aufweist, die in einer Ebene zwischen den Kombi-Segmenten (10) angeordnet ist.

8. Anlage nach einem der Ansprüche 1 bis 7, **dadurch gekennzeichnet, dass** das dem Behandlungswerkzeug (11) zugeordnete Kombi-Segment (10) und/oder ein Substrathalter (17) des Substrates (8) als eine Kammertrennwand (21) ausgebildet ist.

9. Anlage nach Anspruch 7 oder 8, **dadurch gekennzeichnet, dass** die Kammertrennwand (21) mit Dichtelementen (24, 32) einer Kammerwand (25) der Behandlungssektion (1) korrespondiert.

10. Anlage nach einem der vorgenannten Ansprüche, **dadurch gekennzeichnet, dass** die Transportsegmente (5) Elemente einer Rollen-, einer Schienen- oder einer Gaspolster- Transportvorrichtung sind.

11. Anlage nach einem der vorgenannten Ansprüche, **dadurch gekennzeichnet, dass** das Substrat (8) eine Behandlungsfläche aufweist, die beim Inline-Transport des Substrates (8) entlang der Transportlinie (4) eine Transportebene bildet und bei der Positionierung des Substrates (8) in die Behandlungsposition in einer Ebene parallel zur Transportebene ausgerichtet ist.

12. Anlage nach Anspruch 11, **dadurch gekennzeichnet, dass** die Behandlungsfläche des Substrates (8) horizontal oder im Wesentlichen vertikal ausgerichtet ist.

13. Anlage nach einem der vorgenannten Ansprüche, **dadurch gekennzeichnet, dass** die Transportvorrichtung ein Drehmodul (26) mit mindestens einem Transportsegment (5) aufweist, welches den Transportsegmenten (5) zweier Behandlungssektionen (1) zuordenbar ist.

## Claims

1. Apparatus, particularly vacuum coating apparatus, for processing substrates (8) including a transport device, wherein the transport device includes: transport segments (5) arranged in a row for the continuous inline transport of the substrates (8) along a transport line (4) through a plurality of processing sections (1), of which at least one processing section (1) includes a processing tool (11), wherein provided to position a substrate (8) in a stationary processing position there is a transfer means (9), which includes matching, moveable combi segments (10), by means of which the substrate (8) is positioned, wherein the combi segments (10) constitute a transport segment (5) in an alternative location with respect to the transport line (4), wherein the substrate (8) is positionable by means of the combi segments (10) into the stationary processing position, in which the substrate (8) is located opposed to the processing tool.

2. Apparatus as claimed in claim 1, **characterised in that** the combi segments (10) are arranged parallel to and spaced from one another.

3. Apparatus as claimed in claim 1 or 2, **characterised in that** the combi segments (10) are moveable transversely and preferably perpendicularly to the transport line (4).

4. Apparatus as claimed in claim 3, **characterised in that** the combi segments (10) are moveable horizontally and/or vertically.

5. Apparatus as claimed in claim 3 or 4, **characterised in that** the transfer means (9) includes a roller or gear drive with a pushing or pulling means drive, which is operable electrically, pneumatically or hydraulically.

6. Apparatus as claimed in one of the preceding claims, **characterised in that** a respective transfer means (9) is provided in at least two successive processing sections (1) or is associated with at least two successive processing tools (11).

7. Apparatus as claimed in claim one of the preceding claims, **characterised in that** the transfer means (9) includes a chamber partition wall (9), which is arranged in a plane between the combi segments (10).

8. Apparatus as claimed in claims 1 to 7, **characterised in that** the combi segment (10) associated with the processing tool (11) and/or a substrate holder (17) of a substrate (8) is constructed in the form of a chamber partition wall (21).

9. Apparatus as claimed in claim 7 or 8, **characterised in that** the chamber partition wall (21) with sealing elements (24, 32) corresponds to a chamber wall of the processing section (1).

10. Apparatus as claimed in one of the preceding claims, **characterised in that** the transport segments (5) are elements of a roller, track or gas cushion transport device.

11. Apparatus as claimed in one of the preceding claims, **characterised in that** the substrate (8) has a processing surface which, during the inline transport of the substrate (8) along the transport line (4), defines a transport plane and is aligned in a plane parallel to the transport plane during the positioning of the substrate (8) into the processing position.

12. Apparatus as claimed in claim 11, **characterised in that** the processing surface of the substrate (8) is aligned horizontally or substantially vertically.

13. Apparatus as claimed in one of the preceding claims, **characterised in that** the transport device includes a rotary module (26) with at least one transport segment, which is associable with the transport segments (5) of two processing sections (1).

## Revendications

1. Installation, en particulier installation de revêtement sous vide, pour le traitement de substrats (8), comprenant un système de transport, dans laquelle le système de transport comprend :
des segments de transport (5) alignés les uns derrière les autres, prévus pour le transport en ligne et en continu des substrats (8) le long d'une ligne de transport (4), à travers plusieurs sections de traitement (1) parmi lesquelles au moins une section de traitement (1) présente au moins un outil de traitement (11),
dans laquelle un moyen de transfert (9) est prévu pour le positionnement d'un substrat (8) à la fois dans une position de traitement fixe, ledit moyen de transfert comprenant des segments combinés (10) mobiles correspondants au moyen desquels le substrat (8) peut être positionné,
dans laquelle les segments combinés (10) forment un segment de transport (5) dans une disposition alternante par rapport à la ligne de transport (4),
dans laquelle le substrat (8) peut être placé dans la position de traitement fixe au moyen des segments combinés (10), position dans laquelle le substrat (8) se trouve sur le côté opposé de l'outil de traitement (11).

2. Installation selon la revendication 1, **caractérisée en ce que** les segments combinés (10) sont disposés à une certaine distance l'un de l'autre et parallèlement l'un à l'autre.

3. Installation selon la revendication 1 ou 2, **caractérisée en ce que** les segments combinés (10) peuvent être déplacés transversalement et de préférence perpendiculairement à la ligne de transport (4).

4. Installation selon la revendication 3, **caractérisée en ce que** les segments combinés (10) peuvent être déplacés horizontalement et/ou verticalement.

5. Installation selon la revendication 3 ou 4, **caractérisée en ce que** le moyen de transfert (9) présente un mécanisme d'entraînement à galet ou à pignon ou un mécanisme d'entraînement à poussée ou à traction, lequel fonctionne par voie électrique, pneumatique ou hydraulique.

6. Installation selon l'une quelconque des revendications précédentes, **caractérisée en ce qu'**un moyen de transfert (9) est prévu dans chacune d'au moins deux sections de traitement (1) consécutives ou est associé à chacun d'au moins deux outils de traitement (11) consécutifs.

7. Installation selon l'une quelconque des revendications précédentes, **caractérisée en ce que** le moyen de transfert (9) présente une cloison de séparation de chambre (21) disposée dans un plan entre les segments combinés (10).

8. Installation selon l'une quelconque des revendications 1 à 7, **caractérisée en ce que** le segment combiné (10) associé à l'outil de traitement (11) et/ou un support de substrat (17) pour le substrat (8) sont réalisés sous la forme d'une cloison de séparation de chambre (21).

9. Installation selon la revendication 7 ou 8, **caractérisée en ce que** la cloison de séparation de chambre (21) correspond à des éléments d'étanchéité (24, 32) d'une paroi de chambre (25) de la section de traitement (1).

10. Installation selon l'une quelconque des revendications précédentes, **caractérisée en ce que** les segments de transport (5) sont des éléments d'un système de transport à galets, à glissière ou à coussin de gaz.

11. Installation selon l'une quelconque des revendications précédentes, **caractérisée en ce que** le substrat (8) présente une surface de traitement qui forme un plan de transport lorsque le substrat (8) est transporté en ligne le long de la ligne de transport (4), et qui est orientée dans un plan parallèle au plan de transport lorsque le substrat (8) est positionné dans la position de traitement.

12. Installation selon la revendication 11, **caractérisée en ce que** la surface de traitement du substrat (8) est orientée horizontalement ou essentiellement verticalement.

13. Installation selon l'une quelconque des revendications précédentes, **caractérisée en ce que** le système de transport présente un module rotatif (26) comprenant au moins un segment de transport (5) qui peut être associé aux segments de transport (5) de deux sections de traitement (1).
